## Europäisches Patentamt
## European Patent Office
## Office européen des brevets

(19)

(11) Publication number: **0 177 246**
**B1**

(12)
# EUROPEAN PATENT SPECIFICATION

(45) Date of publication of patent specification: **17.08.88**

(51) Int. Cl.⁴: **H 01 L 29/72**

(21) Application number: **85306769.2**

(22) Date of filing: **24.09.85**

(54) Heterojunction bipolar transistor and method of manufacturing the same.

(30) Priority: **29.09.84 JP 204424/84**
**06.06.85 JP 123008/85**

(43) Date of publication of application:
**09.04.86 Bulletin 86/15**

(45) Publication of the grant of the patent:
**17.08.88 Bulletin 88/33**

(84) Designated Contracting States:
**DE FR GB**

(56) References cited:
**EP-A-0 035 111**
**EP-A-0 035 126**
**US-A-4 380 774**

**IEEE ELECTRON DEVICE LETTERS, vol. EDL-3, no. 12, December 1982, pages 366-368, IEEE, New York, US; P.M. ASBECK et al.: "GaAs/GaAlAs heterojunction bipolar transistors with cutoff frequencies above 10 GHz"**

**PATENTS ABSTRACTS OF JAPAN, vol 7, no. 204 (E-197) 1349r, 9th September 198; & JP-A-58 100 456**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Morizuka, Kouhei c/o Patent Division**
**Kabushiki Kaisha Toshiba 1-1 Shibaura 1-chome**
**Minato-ku Tokyo 105 (JP)**

(74) Representative: **Freed, Arthur Woolf et al**
**MARKS & CLERK 57-60 Lincoln's Inn Fields**
**London WC2A 3LS (GB)**

(56) References cited:
**IEEE ELECTRON DEVICE LETTERS, vol. EDL-4, no. 4, April 1983, pages 81-84, IEEE, New York, US; P.M. ASBECK et al.: "Application of thermal pulse annealing to ion-implanted GaAlAs/GaAs heterojunction bipolar transistors"**

## Description

The present invention relates to a heterojunction bipolar transistor and a method of manufacturing the same.

A heterojunction bipolar transistor using an emitter or collector layer having a wider forbidden band gap than that of a base layer is receiving a great deal of attention as a bipolar transistor with a large current amplification factor and a low base resistance. In this bipolar transistor, a base push-out effect is also suppressed. A combination of AlGaAs and GaAs, or InGaAsP and InP has been used for conventional heterojunction bipolar transistors due to relatively easy crystal growth. Wafers for the conventional heterojunction bipolar transistors are formed by LPE (Liquid Phase Epitaxy), MOCVD (Metal Organic Chemical Vapor Deposition) or MBE (Molecular Beam Epitaxy). The heterojunction bipolar transistor has an advantage in that its base resistance can be substantially decreased because an impurity concentration in the base layer can be increased.

How to form the base electrode without impairing this advantage is a conventional problem. For example, a heterojunction bipolar transistor in which the base electrode is directly embedded in the wide gap p-type external base (AlGaAs layer) is described by C. Dubon et al. in, "Double Heterojunction GaAs-GaAlAs Bipolar Transistors Grown by MOCVD for Emitter Coupled Logic Circuits", IEEE, IEDM83, pp. 689—693. With this structure, however, since the base electrode is formed on an AlGaAs layer with a wide forbidden band gap, the contact resistance of the base electrode is increased. In addition, since the AlGaAs layer contains Al, the layer tends to be oxidized, degrading reproducibility of the electrode.

A heterojunction transistor which has a high resistive region between emitter and base is described by P. M. Asbeck et al. in, "Application of Thermal Pulse Annealing to Ion-Implanted GaAlAs/GaAs Heterojunction Bipolar Transistors", IEEE, Electron Device Letters, Vol. EDL-4, No. 4, April 1983, pp. 81—84. With this structure, however, since ion implantation is performed to form the high resistive region, the heterojunction bipolar transistor has a large number of defect/recombination centers generated near the emitter-base junction. Therefore, the current amplification factor is decreased.

It is an object of the present invention to provide an improved heterojunction bipolar transistor having a high current amplification factor and a low base electrode contact resistance.

It is another object of the present invention to provide a method of manufacturing the heterojunction bipolar transistor having the above-mentioned characteristics.

According to an aspect of the present invention, there is provided a heterojunction bipolar transistor comprising:

a first semiconductor layer of a first conductivity type which serves as a collector region;

a second semiconductor layer of a second conductivity type which is formed on the first semiconductor layer and which serves as a base region;

a third semiconductor layer of the first conductivity type which is formed on the second semiconductor layer and which serves as an emitter region, the portion of the third semiconductor layer which contacts the second semiconductor layer having a forbidden band gap that is wider than that of the second semiconductor layer;

an external base region of the second conductivity type formed in the third semiconductor layer so as to surround the emitter region, the external base region being both formed to reach the second semiconductor layer and provided with a recess of a depth sufficient to partially expose the second semiconductor layer;

a base electrode formed contacting an exposed portion of the second semiconductor layer in the recess;

a collector electrode electrically connected to the first semiconductor layer; and

an emitter electrode electrically connected to the third semiconductor layer.

According to another aspect of the present invention, there is provided a method of manufacturing a heterojunction bipolar transistor comprising the steps of:

(a1) epitaxially growing a first semiconductor layer of a first conductivity type on a semiconductor substrate, the first semiconductor layer serving as a collector region;

(a2) epitaxially growing a second semiconductor layer of a second conductivity type on the first semiconductor layer, the second semiconductor layer serving as a base region;

(a3) epitaxially growing a third semiconductor layer of the first conductivity type on the second semiconductor layer, the third semiconductor layer serving as an emitter region, and that portion of the third semiconductor layer which contacts the second semiconductor layer having a forbidden band gap that is wider than that of the second semiconductor layer;

(a4) doping an impurity in the third semiconductor layer so as to surround the emitter region to form an external base region of the second conductivity type having a depth reaching the second semiconductor layer;

(a5) partially etching the external base region to expose the second semiconductor layer;

(a6) forming a base electrode so as to contact an exposed portion of the second semiconductor layer; and

(a7) forming emitter and collector electrodes, electrically connected to the emitter region and the first semiconductor layer, respectively.

Other objects and advantages will be apparent from the following description, given in conjunction with the accompanying drawings, in which:

Fig. 1 is a sectional view of a heterojunction bipolar transistor according to a first embodiment of the present invention;

Figs. 2A to 2D are sectional views explaining steps in manufacturing the heterojunction bipolar transistor shown in Fig. 1;

Fig. 3 is a plan view of the device of Fig. 2D;

Fig. 4 is a graph showing the relationship between the collector current and the current amplification factor of the heterojunction bipolar transistor of the present invention;

Fig. 5 is a graph showing the relationship between the collector current and the cut-off frequency fT of the heterojunction bipolar transistor of the present invention; and

Figs. 6A to 6E are sectional views explaining the steps in manufacturing a heterojunction bipolar transistor according to a second embodiment of the present invention.

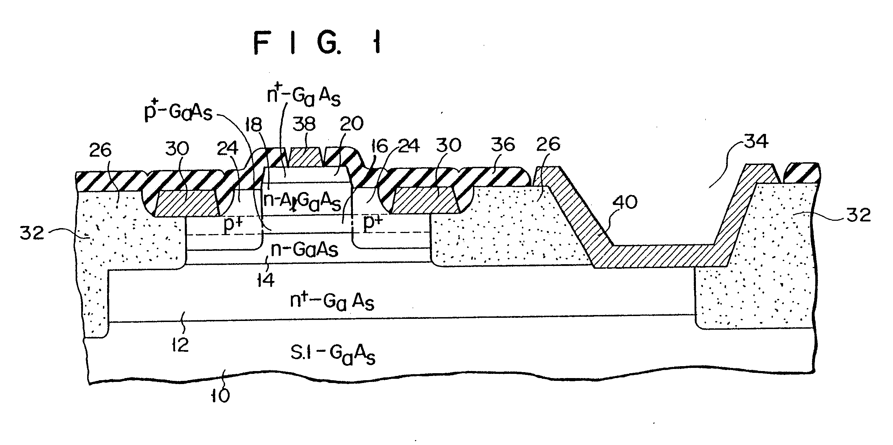

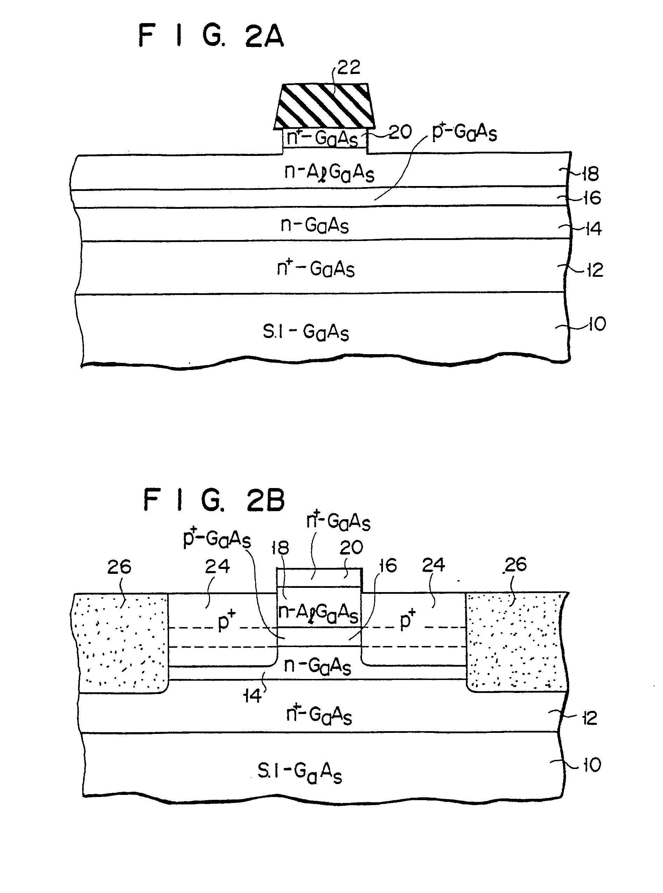

A heterojunction bipolar transistor according to a first embodiment of the present invention will be described with reference to Figs. 1 to 3. Fig. 1 shows the structure of an AlGaAs-GaAs heterojunction bipolar transistor. The structure will be described in accordance with the manufacturing steps in Figs. 2A to 2D. (For ease of illustration, a collector electrode is not illustrated in Figs. 2A to 2D).

In this embodiment, semiconductor layers for the collector, base and emitter of the transistor are epitaxially grown by MOCVD. However, MBE can be used in place of MOCVD. As shown in Fig. 2A, a first semiconductor layer serving as a collector is formed on a semi-insulating GaAs substrate 10. The first semiconductor layer comprises an $n^+$-type GaAs layer 12 epitaxially grown on the GaAs substrate 10, and an n-type GaAs layer 14 epitaxially grown on the layer 12. A second semiconductor layer serving as a base is epitaxially grown on the first semiconductor layer. The second semiconductor layer comprises a $p^+$-type GaAs layer 16. A third semiconductor layer serving as an emitter is epitaxially grown on the second semiconductor layer. The third semiconductor layer comprises an n-type AlGaAs layer 18 epitaxially grown on the layer 16, and an $n^+$-type GaAs layer 20 epitaxially grown on the layer 18. Thicknesses of the layers 12, 14, 16, 18 and 20 are 0.5 μm, 0.5 μm, 0.1 μm, 0.2 μm and 0.1 μm, respectively. The composition ratio of Al to GaAs in the layer 18 is 0.25:0.75. After the epitaxial wafer described above is formed, an $SiO_2$ film mask 22 having a thickness of 0.8 μm is formed by photolithography on a prospective emitter region. By using the mask 22, the uppermost layer 20 and a predetermined thickness of the layer 18 are etched to expose the layer 18.

As shown in Fig. 2B, Mg ions are implanted at a dose of $2 \times 10^{14}/cm^2$ and an acceleration voltage of 200 keV, while the mask 22 is left intact. Thereafter, annealing is performed to form a low resistance $p^+$-type layer 24 which serves as an external base region. Subsequently, a mask is formed to cover a portion from the emitter region to part of the external base region, and B ions are implanted at a dose of $7 \times 10^{12}/cm^2$ and an acceleration voltage of 150 keV. This ion-implanted layer is annealed to form a high resistance layer 26 for isolating the base from the collector.

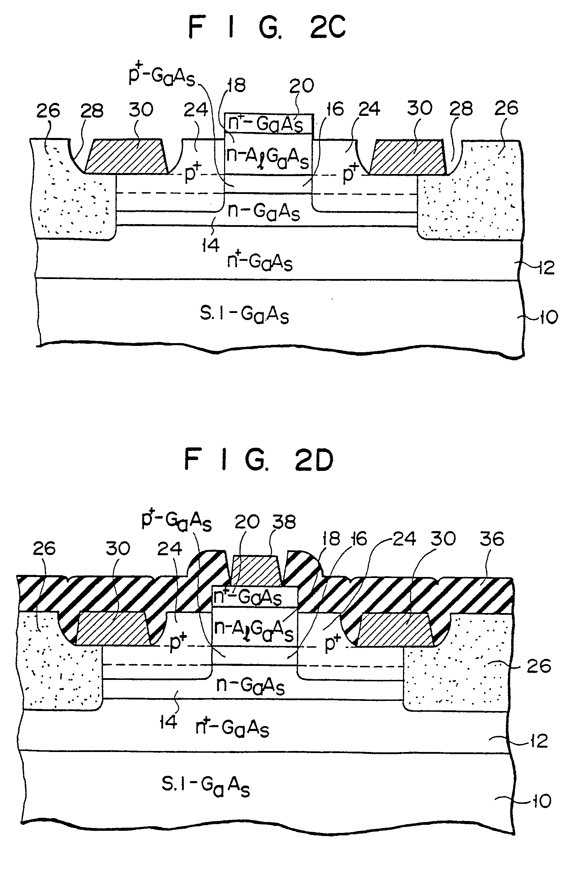

Thereafter, as shown in Fig. 2C, a photoresist pattern having an opening corresponding to a prospective base electrode is formed, and the layer 18 is etched to form a recess 28 extending from part of the external base region to part of the layer 26. The layer 16 is exposed at the bottom surface of the recess 28. Since slight Al diffusion from the layer 18 is present in the layer 16, the surface of the layer 16 should, preferably, be overetched to remove the Al diffusion layer. After the layer 16 is exposed, a Au-Zn alloy is deposited while the photoresist pattern is left intact. The photoresist is subsequently removed by a lift-off technique to form a base electrode 30.

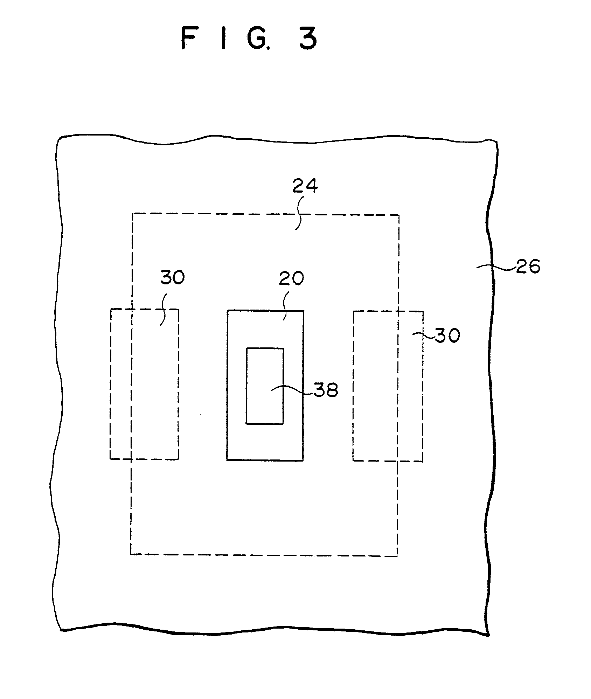

As shown in Fig. 1, a high resistance element isolation layer 32 is formed by proton ion implantation. Etching is also performed to form a contact hole 34 for the collector electrode. Thereafter, the entire surface of the resultant structure is covered with a $CVD-SiO_2$ film 36, as shown in Figs. 1 and 2D. The oxide film 36 is selectively etched and a Au-Ge alloy film is deposited and then lifted off to form emitter and collector electrodes 38 and 40. Now, Fig. 3 is a plan view of the device of Fig. 2D.

In the bipolar transistor of this embodiment, a sheet resistance of the external base region 24 formed by ion implantation is 300 Ω/□, which is smaller than the sheet resistance of 1 kΩ/□ of the internal base layer 16. Furthermore, a p-n junction formed in the surface layer of the element comprises a homojunction in the AlGaAs layer having a wide forbidden band gap. Therefore, a wasteful current which does not contribute to the operation of the intrinsic transistor can not flow through the homojunction. Consequently, a high current amplification factor can be obtained.

A high resistance layer is required in the device described by P. M. Asbeck et al. in, "Application of Thermal Pulse Annealing to Ion-Implanted GaAlAs/GaAs heterojunction Bipolar Transistors", IEEE, Electron Device Letters, Vol. EDL-4, No. 4, April 1983, pp. 81—84. However, the high resistance layer need not be formed in the present invention to eliminate the p-n homojunction of the GaAs layer having a narrow forbidden band gap. A low sheet resistance is maintained in the external base region, and generation/recombination centers are not formed near the emitter-base junction. According to the effect described above, the heterojunction bipolar transistor has a high current amplification factor and can be operated at high speed.

In the above embodiment, since the base electrode 30 contacts the $p^+$-type GaAs layer 16 doped with a high concentration impurity and having a narrow forbidden band gap, its specific contact resistance is about $3 \times 10^{-7}$ Ωcm². This value is about 1/10 that of the device described by C. Dubon et al. in, "Double Heterojunction GaAs-GaAlAs Bipolar Transistors Grown by MOCVD for Emitter Coupled Logic Circuits", IEEE, IEDM83, pp. 689—693. As such, good reproducibility of the contact resistance of the base electrode 30 can be accomplished in the transistor of this embodiment.

Furthermore, since the emitter electrode 38 is connected to the layer 20 doped with a high concentration impurity, its specific contact resistance is as small as about $5 \times 10^{-7}$ $\Omega cm^2$. Therefore, the heterojunction bipolar transistor of this embodiment can be operated with a high current density of $1 \times 10^5$ $A/cm^2$.

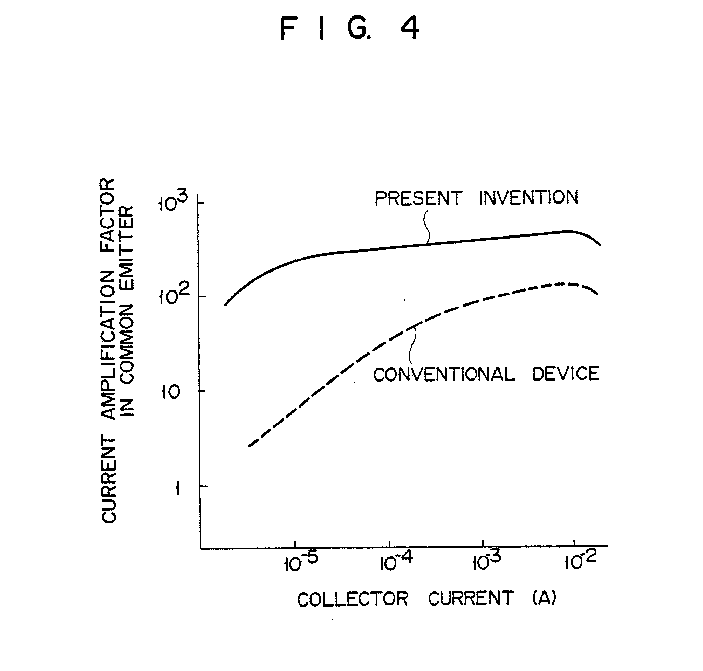

Fig. 4 shows a common emitter current amplification factor of the transistor of this embodiment, as compared with that of a conventional transistor. The conventional transistor is a device having a high resistance layer to eliminate a p-n homojunction of a GaAs layer. The emitter size of the heterojunction bipolar transistor used in this experiment is 2 $\mu m \times 5$ $\mu m$. In the conventional transistor, the carrier recombination rate is high due to an ion doped damage layer formed near the emitter-base junction, resulting in a substantial decrease of the current amplification factor in the low collector current region. According to this embodiment, however, a high current amplification factor, even in a low collector current region, can be obtained.

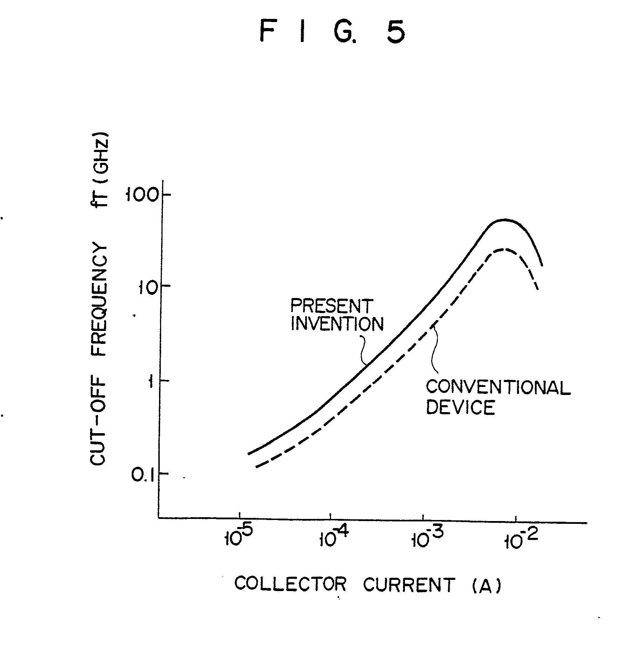

Fig. 5 shows the cut-off frequency fT of the transistor of this embodiment, as compared with that of the conventional transistor. In the conventional transistor having a high resistance layer, when the emitter-base junction is forward biased, electrons and holes are injected into the high resistance region formed near the emitter-base junction surface. The injection carriers serve as an accumulation capacitor connected in parallel with the emitter-base junction. For this reason, the cut-off frequency characteristics of the conventional heterojunction bipolar transistor are degraded. According to this embodiment, however, the accumulation effect can be eliminated, thereby improving the cut-off frequency.

By employing the structure of the present invention, the electrical characteristics of the heterojunction bipolar transistor can be greatly improved in a DC and high-frequency range.

The above embodiment is exemplified by the AlGaAs/GaAs heterojunction bipolar transistor. The present invention can also be applied to a device manufactured by other semiconductor materials. Furthermore, in the above embodiment the external base region is formed by ion implantation. However, the external base region may be formed by Zn diffusion or the like. In the above embodiment, the emitter junction comprises a heterojunction. However, the collector junction may also comprise a heterojunction.

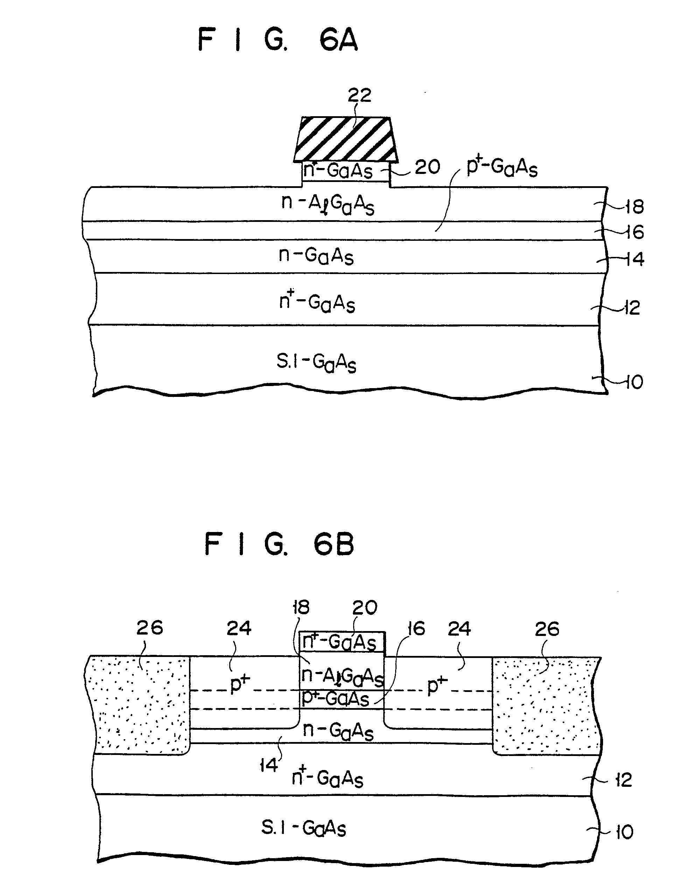

A heterojunction bipolar transistor according to the second embodiment of the present invention will be described with reference to Figs. 6A to 6E. As shown in Fig. 6A, a first semiconductor layer serving as a collector is formed by MBE on a semi-insulating GaAs substrate 10. The first semiconductor layer comprises an $n^+$-type GaAs layer 12 epitaxially grown on the substrate 10, and an n-type GaAs layer 14 epitaxially grown on the layer 12. The layer 12 has a thickness of 0.5 $\mu m$ so as to acheive good ohmic contact with a collector electrode. The layer 14 has a thickness of 0.5 $\mu m$.

A second semiconductor layer serving as a base is epitaxially grown on the first semiconductor layer. The second semiconductor layer comprises a 0.1 $\mu m$ thick $p^+$-type GaAs layer 16. A third semiconductor layer, as an emitter, is epitaxially grown on the second semiconductor layer. The third semiconductor layer comprises a 0.2 $\mu m$ thick n-type AlGaAs layer 18, and a 0.5 $\mu m$ thick $n^+$-type GaAs layer 20. A heterojunction is formed between the layer 16 as the second semiconductor layer and the layer 18 of the third semiconductor layer. The ratio of Al to Ga in the layer 18 is, for example, 3:7. After such an epitaxial wafer is prepared, an $SiO_2$ film mask 22 having a thickness of 0.8 $\mu m$ is formed on a prospective emitter region by photolithography. By using the mask 22, the uppermost layer 20 and a predetermined thickness of the layer 18 are etched to expose the layer 18.

As shown in Fig. 6B, Mg ions are implanted at a dose of $2 \times 10^{14}/cm^2$ and an acceleration voltage of 200 keV while the mask 22 is left intact. Thereafter, annealing is performed to form a low resistance $p^+$-type layer 24 serving as an external base region. Subsequently, a mask is formed to cover a portion extending from the emitter region to part of the external base region, and B ions are implanted at a dose of $7 \times 10^{12}/cm^2$ and an acceleration voltage of 150 keV. This ion-implanted layer is annealed to form a high resistance layer 26 for separating the base from the collector.

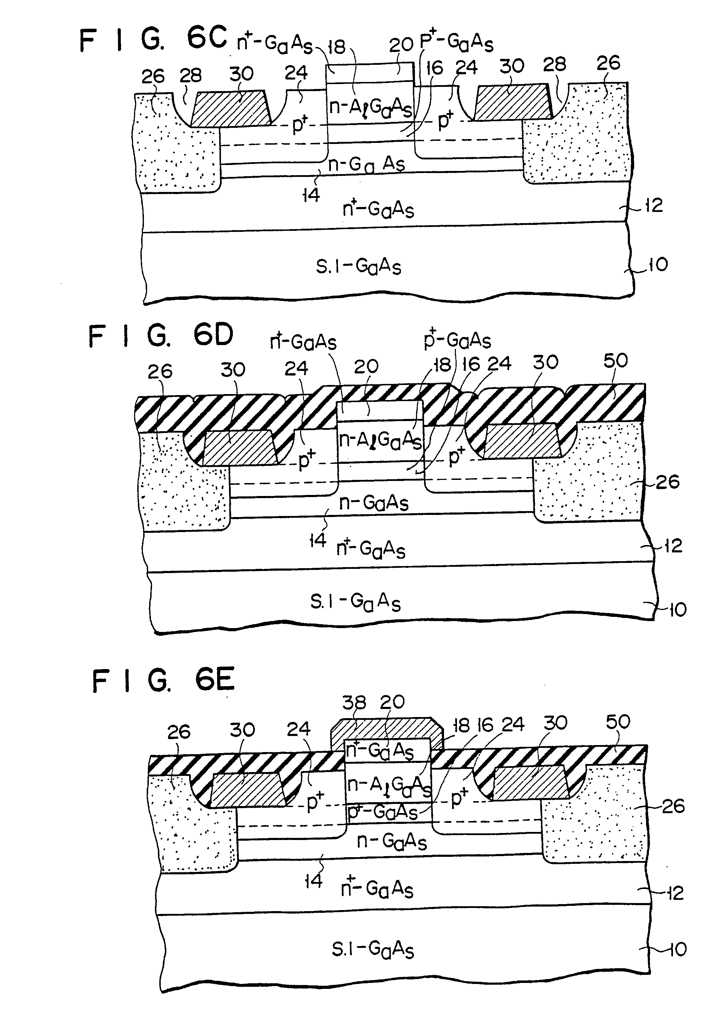

As shown in Fig. 6C, a photoresist pattern having an opening corresponding to a prospective base electrode region is formed. By using this pattern, the layer 18 is etched to form a recess 28 extending from part of the external base region to part of the high resistance layer 26. In this case, the layer 16 is exposed at the bottom surface of the recess 28. Since slight Al diffusion from the layer 18 to the layer 16 is present, the surface layer of the layer 16 should, preferably, be overetched to remove the Al diffusion layer. After the layer 16 is partially exposed, a Au-Zn alloy is deposited while the photoresist pattern is left intact. The photoresist is then lifted off by a solvent to form a base electrode 30.

As shown in Fig. 6D, a silica solution (e.g., OCD solution available from Tokyo Oka K.K.) is spin coated at a speed of 2,000 rpm to form a film on the entire surface which is then annealed at 300°C to form a 0.5 $\mu m$ thick $SiO_2$ film 50. The thickness of the film 50 on the projected emitter region is as thin as about 0.1 $\mu m$, and the film has a substantially flat surface.

As shown in Fig. 6E, the $SiO_2$ film 50 is etched by RIE, using $CF_4$ gas to expose the top surface and a part of the side surface of the $n^+$-type GaAs layer 20 of the emitter region. An emitter electrode 38 is formed by deposition of a Au-Ge film and a lift-off technique. The electrode 38 contacts at least the top surface of the layer 20. The electrode 38 is alloyed with GaAs by annealing at a temperature of about 400°C, thereby providing good ohmic contact between the electrode 38 and the layer 20.

Formation of a base wiring layer for the base electrode is omitted. However, in practice, a contact hole is formed in the film 50 on the electrode 30 to form the base wiring layer. As for the collector electrode, mesa etching is performed at a predetermined location to expose the $n^+$-type GaAs layer 12, and a Au-Ge film is formed through this contact hole to contact the collector region. When a plurality of the above-mentioned transistors are integrated, an element isolation region may be formed by radiation of proton.

According to the second embodiment, the following effects can be obtained in addition to those of the first embodiment.

The electrode 38 can be formed by using a mask pattern larger than the emitter region so that the emitter electrode 38 can be formed to contact the entire surface of the emitter region. Therefore, the emitter-contact resistance can be decreased. The size of the emitter region is determined by RIE of Fig. 6A, and the emitter electrode width can be increased to be greater than the emitter region width. Therefore, the emitter region size can be decreased to its treatment limit, thereby obtaining a high-performance heterojunction bipolar transistor.

## Claims

1. A heterojunction bipolar transistor comprising:

a first semiconductor layer (12, 14) of a first conductivity type which serves as a collector region;

a second semiconductor layer (16) of a second conductivity type which is formed on said first semiconductor layer (12, 14) and which serves as a base region;

a third semiconductor layer (18, 20) of the first conductivity type which is formed on said second semiconductor layer (16) and which serves as an emitter region, the portion of the third semiconductor layer (18) which contacts said second semiconductor layer having a forbidden band gap that is wider than that of said second semiconductor layer (16);

an external base region (24) of the second conductivity type which is formed in said third semiconductor layer (18) so as to surround said emitter region, said external base region (24) being formed to reach said second semiconductor layer (16);

a collector electrode (40) electrically connected to said first semiconductor layer (12);

a base electrode (30) electrically connected to said second semiconductor layer (16); and

an emitter electrode (38) electrically connected to said third semiconductor layer (20), characterized in that:

said external base region (24) comprises a recess (28) of a depth sufficient to partially expose said second semiconductor layer (16); and

said base electrode (30) is formed contacting an exposed portion of said second semiconductor layer (16) in said recess (28).

2. The transistor according to claim 1, characterized in that said external base region (24) is formed contacting only said portion (18) of said third semiconductor layer having the wide forbidden band gap.

3. The transistor according to claim 1, characterized in that:

said first semiconductor layer comprises an $n^+$-type GaAs layer (12) formed on a semi-insulating GaAs substrate (10), and an n-type GaAs layer (14) formed on said $n^+$-type GaAs layer (12);

said second semiconductor layer comprises a $p^+$-type GaAs layer (16) formed on said n-type GaAs layer (14); and

said third semiconductor layer comprises an n-type AlGaAs layer (18) formed on said $p^+$-type GaAs layer (16), and an $n^+$-type GaAs layer (20) formed on said n-type AlGaAs layer (18).

4. The transistor according to claim 3, characterized by further comprising insulating means (36, 50) for isolating said external base region (24) from said $n^+$-type GaAs layer (20) constituting said third semiconductor layer.

5. The transistor according to claim 4, characterized in that said insulating means (36, 50) comprises an $SiO_2$ film.

6. The transistor according to claim 1, characterized in that said emitter electrode (38) is formed to contact at least the top surface of the third semiconductor layer.

7. A method of manufacturing a heterojunction bipolar transistor, characterized by comprising the steps of:

(a1) epitaxially growing a first semiconductor layer (12, 14) of a first conductivity type on a semiconductor substrate (10), said first semiconductor layer (12, 14) serving as a collector region;

(a2) epitaxially growing a second semiconductor layer (16) of a second conductivity type on the first semiconductor layer (12, 14), said second semiconductor layer (16) serving as a base region;

(a3) epitaxially growing a third semiconductor layer (18, 20) of the first conductivity type on said second semiconductor layer (16), said third semiconductor layer (18, 20) serving as an emitter region, and that portion of said third semiconductor layer (18) which contacts said second semiconductor layer (16) having a forbidden band gap that is wider than that of said second semiconductor layer (16);

(a4) doping an impurity in said third semiconductor layer so as to surround the emitter region to form an external base region (24) of the second conductivity type having a depth reaching said second semiconductor layer (16);

(a5) partially etching the external base region to expose said second semiconductor layer (16);

(a6) forming a base electrode (30) so as to contact an exposed portion of said second semiconductor layer; and

(a7) forming an emitter electrode (38) and a collector electrode (40), electrically connected to said emitter region and said first semiconductor layer, respectively.

8. The method according to claim 7, characterized in that:

the step (a1) comprises the substeps of:

(b1) preparing a semi-insulating GaAs substrate (10),

(b2) epitaxially growing an $n^+$-type GaAs layer (12) on said semi-insulating GaAs substrate (10), and

(b3) epitaxially growing an n-type GaAs layer (14) on said $n^+$-type GaAs layer (12);

the step (a2) comprises the substep of:

(c1) epitaxially growing a $p^+$-type GaAs layer (16) on said n-type GaAs layer (14); and

the step (a3) comprises the substeps of:

(d1) epitaxially growing an n-type AlGaAs layer (18) on said $p^+$-type GaAs layer, and

(d2) epitaxially growing an $n^+$-type GaAs layer (20) on said n-type AlGaAs layer (18).

9. The method according to claim 8, characterized by further comprising the steps of:

(e1) forming a mask (22) on said $n^+$-type GaAs layer after the substep (d2) is performed; and

(e2) etching said $n^+$-type GaAs layer (20) by using said mask (22), and then etching said n-type AlGaAs layer (18) to a predetermined depth to expose said AlGaAs layer (18).

10. The method according to claim 9, characterized by further comprising the steps of:

(f1) forming an insulating film (36) to cover an entire surface after the step (a6) is performed; and

(f2) selectively etching said insulating film (36) to form an opening for forming said emitter electrode (38).

11. The method according to claim 7, characterized by further comprising the steps of:

(g1) forming an insulating film (50) to cover an entire surface after the step (a6) is performed; and

(g2) etching said insulating film (50) to expose a projecting surface of said emitter region.

12. The method according to claim 11, characterized in that the step (a7) comprises the step of forming said emitter electrode (38) to cover an exposed portion of the surface of said emitter region.

**Patentansprüche**

1. Heteroübergangbipolartransistor, umfassend eine als Kollektorzone dienende erste Halbleiterschicht (12, 14) eines ersten Leitfähigkeitstyps,

eine auf der ersten Halbleiterschicht (12, 14) erzeugte und als Basiszone dienende zweite Halbleiterschicht (16) eines zweiten Leitfähigkeitstyps,

eine auf der zweiten Halbleiterschicht (16) erzeugte und als Emitterzone dienende, den ersten Leitfähigkeitstyp aufweisende dritte Halbleiterschicht (18, 20), deren die zweite Halbleiterschicht kontaktierender Bereich (18) einen verbotenen Bandabstand aufweist, der weiter ist als derjenige der zweiten Halbleiterschicht (16),

eine den zweiten Leitfähigkeitstyp aufweisende externe Basiszone (24), die in der dritten Halbleiterschicht (18) die Emitterzone umschließend ausgebildet und so geformt ist, daß sie an die zweite Halbleiterschicht (16) heranreicht,

eine elektrisch mit der ersten Halbleiterschicht (12) verbundene Kollektorelektrode (40),

eine elektrisch mit der zweiten Halbleiterschicht (16) verbundene Basiselektrode (30) und

eine elektrisch mit der dritten Halbleiterschicht (20) verbundene Emitterelektrode (38), dadurch gekennzeichnet, daß

die externe Basiszone (24) eine Ausnehmung (28) einer solchen Tiefe, daß sie die zweite Halbleiterschicht (16) teilweise freilegt, umfaßt und

die Basiselektrode (30) in Kontakt (oder Berührung) mit einem freigelegten Bereich der zweiten Halbleiterschicht (16) in der Ausnehmung (28) ausgebildet ist.

2. Transistor nach Anspruch 1, dadurch gekennzeichnet, daß die Basiszone (24) so ausgebildet ist, daß sie nur den den weiten verbotenen Bandabstand aufweisenden Bereich (18) der dritten Halbleiterschicht kontaktiert.

3. Transistor nach Anspruch 1, dadurch gekennzeichnet, daß

die erste Halbleiterschicht eine auf einem halbisolierenden GaAs-Substrat (10) erzeugte $n^+$-Typ-GaAs-Schicht (12) und eine auf der $n^+$-Typ-GaAs-Schicht (12) erzeugte n-Typ-GaAs-Schicht (14) umfaßt,

die zweite Halbleiterschicht eine auf der n-Typ-GaAs-Schicht (14) erzeugte $p^+$-Typ-GaAs-Schicht (16) umfaßt und

die dritte Halbleiterschicht eine auf der $p^+$-Typ-GaAs-Schicht (16) erzeugte n-Typ-AlGaAs-Schicht (18) sowie eine auf der n-Typ-AlGaAs-Schicht (18) erzeugte $n^+$-Typ-GaAs-Schicht (20) umfaßt.

4. Transistor nach Anspruch 3, gekennzeichnet durch ein Isoliermittel (36, 50) zum Trennen der externen Basiszone (24) von der die dritte Halbleiterschicht bildenden $n^+$-Type-GaAs-Schicht (20).

5. Transistor nach Anspruch 4, dadurch gekennzeichnet, daß das Isoliermittel (36, 50) ein $SiO_2$-Film ist.

6. Transistor nach Anspruch 1, dadurch gekennzeichnet, daß die Emitterelektrode (38) so ausgebildet ist, daß sie zumindeste die Oberseite der dritten Halbleiterschicht kontaktiert.

7. Verfahren zur Herstellung eines Heteroübergangbipolartransistors, gekennzeichnet durch die folgenden Verfahrensschritte:

(a1) epitaxiales Aufwachsen einer als Kollektorzone dienenden ersten Halbleiterschicht (12, 14) eines ersten Leitfähigkeitstyps auf einem Halbleitersubstrat (10),

(a2) epitaxiales Aufwachsen einer als Basiszone dienenden zweiten Halbleiterschicht (16) eines zweiten Leitfähigkeitstyps auf der ersten Halbleiterschicht (12, 14),

(a3) epitaxiales Aufwachsen einer als Emitterzone dienenden dritten Halbleiterschicht (18, 20) des ersten Leitfähigkeitstyps auf der zweiten Halbleiterschicht (16), wobei der die zweite Halbleiterschicht (16) kontaktierende Bereich der dritten Halbleiterschicht (18) einen verbotenen Bandabstand aufweist, der weiter ist als derjenige der zweiten Halbleiterschicht (16),

(a4) Dotieren der dritten Halbleiterschicht mit einem Fremdatom oder -stoff, die Emitterzone umschließend, zwecks Ausbildung einer den zweiten Leitfähigkeitstyp aufweisenden externen Basiszone (24) einer bis an die zweite Halbleiterschicht (16) heranreichenden Tiefe,

(a5) teilweises Ätzen der externen Basiszone zwecks Freilegung der zweiten Halbleiterschicht (16),

(a6) Ausbilden einer einen freigelegten Bereich der zweiten Halbleiterschicht kontaktierenden Basiselektrode (30) und

(a7) Ausbilden einer Emitterelektrode (38) und einer Kollektorelektrokde (40), die elektrisch mit Emitterzone bzw. erster Halbleiterschicht verbunden sind.

8. Verfahren nach Anspruch 7, dadurch gekennzeichnet, daß

der Verfahrensschritt (a1) die folgenden Unterschritte umfaßt:

(b1) Bereitstellen eines halbisolierenden GaAs-Substrats (10),

(b2) epitaxiales Aufwachsen einer n$^+$-Typ-GaAs-Schicht (12) auf dem halbisolierenden GaAs-Substrat (10) und

(b3) epitaxiales Aufwachsen einer n-Typ-GaAs-Schicht (14) auf der n$^+$-Typ-GaAs-Schicht (12);

der Verfahrensschritt (a2) den folgenden Unterschritt umfaßt:

(c1) epitaxiales Aufwachsen einer p$^+$-Typ-GaAs-Schicht (16) auf der n-Typ-GaAs-Schicht (14); und

der Verfahrensschritt (a3) die folgenden Unterschritte umfaßt:

(d1) epitaxiales Aufwachsen einer n-Typ-AlGaAs-Schicht (18) auf der p$^+$-Typ-GaAs-Schicht und

(d2) epitaxiales Aufwachsen einer n$^+$-Typ-GaAs-Schicht (20) auf der n-Typ-AlGaAs-Schicht (18).

9. Verfahren nach Anspruch 8, gekennzeichnet durch folgende weitere Verfahrensschritte:

(e1) Ausbilden einer Maske (22) auf der n$^+$-Typ-GaAs-Schicht nach Durchführung von Unterschritt (d2) und

(e2) Ätzen der n$^+$-Typ-GaAs-Schicht (20) unter Heranziehung der Maske (22) und anschließendes Ätzen der n-Typ-AlGaAs-Schicht (18) auf eine vorbestimmte Tiefe zwecks Freilegung der AlGaAs-Schicht (18).

10. Verfahren nach Anspruch 9, gekennzeichnet durch die folgenden weiteren Verfahrensschritte:

(f1) Ausbilden eines eine Gesamt(ober)fläche bedeckenden Isolierfilms (36) nach Durchführung von Verfahrensschritt (a6) und

(f2) selektives Ätzen des Isolierfilms (36) zwecks Ausbildung einer Öffnung für die Erzeugung der Emitterelektrode (38).

11. Verfahren nach Anspruch 7, gekennzeichnet durc die folgenden Verfahrensschritte:

(g1) Ausbilden eines eine Gesamt(ober)fläche bedeckenden Isolierfilms (50) nach Durchführung von Verfahrensschritt (a6) und

(g2) Ätzen des Isolierfilms (50) zwecks Freilegung einer vorspringenden Fläche der Emitterzone.

12. Verfahren nach Anspruch 11, dadurch gekennzeichnet, daß Verfahrensschritt (a7) den Schritt der Erzeugung der einen freigelegten Bereich der Oberfläche der Emitterzone bedekkenden Emitterelektrode (38) umfaßt.

**Revendications**

1. Transistor bipolaire hétérojonction comportant:

une première couche semi-conductrice (12, 14) d'un premier type de conductivité servant de région de collecteur;

une seconde couche semi-conductrice (16) d'un second type de conductivité, formée sur ladite première couche semi-conductrice (12, 14) et servant de région de base;

une troisième couche semi-conductrice (18, 20) du premier type de conductivité, formée sur ladite seconde couche semi-conductrice (16) et servant de région d'émetteur, la partie de la troisième couche semi-conductrice (18) qui est en contact avec ladite seconde couche semi-conductrice ayant un intervalle de bande interdite qui est plus large que celui de ladite seconde couche semi-conductrice (16);

une région de base extérieure (24) du second type de conductivité, formée sur ladite troisième couche semi-conductrice (18) de manière à entourer ladite région d'émetteur, ladite région de base extérieure (24) étant formée pour atteindre ladite seconde couche semi-conductrice (16);

une électrode de collecteur (40) connectée électriquement à ladite première couche semi-conductrice (12);

une électrode de base (30) connectée électriquement à ladite seconde couche semi-conductrice (16); et

une électrode d'émetteur (38) connectée électriquement à ladite troisième couche semi-conductrice (20), caractérisé en ce que:

ladite région de base extérieure (24) comporte un logement (28) d'une profondeur suffisante pour exposer partiellement ladite seconde couche semi-conductrice (16); et

ladite électrode de base (30) est formée pour être en contact avec une partie exposée de ladite seconde couche semi-conductrice (16) dans ledit logement (28).

2. Transistor selon la revendication 1, caractérisé en ce que ladite région de base extérieure (24) est formée en contact avec seulement ladite partie (18) de ladite troisième couche semi-conductrice ayant le large intervalle de bande interdite.

3. Transistor selon la revendication 1, caractérisé en ce que:

ladite première couche semi-conductrice consiste en une couche (12) de GaAs du type N$^+$ formée sur un substrat (10) de GaAs semi-isolant et une couche (14) de GaAs de type N formée sur ladite couche (12) de GaAs de type N$^+$;

ladite seconde couche semi-conductrice consiste en une couche (16) de GaAs de type P$^+$ formée sur ladite couche (14) de GaAs de type N; et

ladite troisième semi-conductrice consiste en une couche (18) de AlGaAs de type N formée sur ladite couche (16) de GaAs de type P$^+$ et une couche (20) de GaAs de type N$^+$ formée sur ladite couche (18) de AlGaAs de type N.

4. Transistor selon la revendication 3, caractérisé en ce qu'il comporte en outre un dispositif d'isolement (36, 50) destiné à isoler ladite région de base extérieure (24) de ladite couche (20) de GaAs de type N$^+$ constituant ladite troisième couche semi-conductrice.

5. Transistor selon la revendication 4, caractérisé en ce que ledit dispositif d'isolement (36, 50) consiste en une pellicule de SiO$_2$.

6. Transistor selon la revendication 1, caractérisé en ce que ladite électrode d'émetteur (38) est formée pour être en contact au moins avec la surface supérieure de ladite troisième couche semi-conductrice.

7. Procédé de fabrication d'un transistor bipolaire hétérojonction, caractérisé en ce qu'il consiste:

(a1) à former par croissance épitaxiale une première couche semi-conductrice (12, 14) d'un premier type de conductivité sur un substrat semi-conducteur (10), ladite première couche semi-conductrice (12, 14) servant de région de collecteur;

(a2) à former par croissance épitaxiale une seconde couche semi-conductrice (16) d'un second type de conductivité sur la première couche semi-conductrice (12, 14), ladite seconde couche semi-conductrice (16) servant de région de base;

(a3) à former par croissance épitaxiale une troisième couche semi-conductrice (18, 20) du premier type de conductivité sur ladite seconde couche semi-conductrice (16), ladite troisième couche semi-conductrice (18, 20) servant de région d'émetteur et la partie de ladite troisième couche semi-conductrice (18) qui est en contact avec la seconde couche semi-conductrice (16) ayant un intervalle de bande interdite qui est plus large que celui de ladite seconde semi-conductrice (16);

(a4) à doper une impureté dans ladite troisième couche semi-conductrice de manière à entourer la région d'émetteur pour former une région de base extérieure (24) du second type de conductivité ayant une profondeur qui atteint ladite seconde couche semi-conductrice (16);

(a5) à graver partiellement la région de base extérieure pour exposer ladite seconde couche semi-conductrice (16);

(a6) à former une électrode de base (30) de manière qu'elle soit en contact avec une partie exposée de ladite seconde couche semi-conductrice; et

(a7) à former une électrode d'émetteur (38) et une électrode de collecteur (40) connectées électriquement à ladite région d'émetteur et à ladite première couche semi-conductrice respectivement.

8. Procédé selon la revendication 7, caractérisé en ce que:

la phase (a1) comporte les sous-phases:

(b1) de préparation d'un substrat de GaAs semi-isolant (10),

(b2) à former par croissance épitaxiale une couche (12) de GaAs de type N$^+$ sur ledit substrat (10) de GaAs semi-isolant, et

(b3) à former par croissance épitaxiale une couche (14) de GaAs de type N sur ladite couche (12) de GaAs de type N$^+$;

la phase (a2) comprenant les sous-phases:

(c1) de formation épitaxiale d'une couche (16) de GaAs de type P$^+$ sur ladite couche (14) de GaAs du type N; et

la phase (a3) comprenant les sous-phases:

(d1) de formation par croissance épitaxiale d'une couche (18) de AlGaAs de type N sur ladite couche de GaAs de type P$^+$, et

(d2) de formation par croissance épitaxiale d'une couche (20) de GaAs de type N$^+$ sur ladite couche (18) de AlGaAs de type N.

9. Procédé selon la revendication 8, caractérisé en ce qu'il consiste également:

(e1) à former un masque (22) sur ladite couche de GaAs de type N$^+$ après que la sous-phase (d2) a été exécutée; et

(e2) à graver ladite couche (20) de GaAs de type N$^+$ en utilisant ledit masque (22) et à graver ensuite ladite couche (18) de AlGaAs de type N jusqu'à une profondeur prédéterminée pour exposer ladite couche (18) de AlGaAs.

10. Procédé selon la revendication 9, caractérisé en ce qu'il consiste en outre:

(f1) à former une pellicule isolante (36) pour recouvrir une surface entière après que la phase (a6) a été exécutée; et

(f2) à graver sélectivement ladite pellicule isolante (36) pour former une ouverture afin de former ladite électrode d'émetteur (38).

11. Procédé selon la revendication 7, caractérisé en ce qu'il consiste en outre:

(g1) à former une pellicule isolante (50) pour recouvrir une surface entière après que la phase (a6) a été exécutée; et

(g2) à graver ladite pellicule isolante (50) afin d'exposer une surface en saillie de ladite région d'émetteur.

12. Procédé selon la revendication 11, caractérisé en ce que la phase (a7) consiste à former ladite électrode d'émetteur (38) pour couvrir une partie exposée de la surface de ladite région d'émetteur.

# F I G. 1

0 177 246

# F I G. 2A

22

n⁺-GaAs 20 p⁺-GaAs

n-AℓGaAs 18

16

n-GaAs 14

n⁺-GaAs 12

S.I - GaAs 10

# F I G. 2B

n⁺-GaAs

p⁺-GaAs 18 20

26 24 16 24 26

p⁺ n-AℓGaAs p⁺

n-GaAs

14

n⁺-GaAs 12

S.I-GaAs 10

**0 177 246**

## F I G. 2C

## F I G. 2D

# F I G. 3

# F I G. 4

# F I G. 5

# F I G. 6A

# F I G. 6B

7

F I G. 6C

F I G. 6D

F I G. 6E